# FASCICULE DE BREVET EUROPEEN

(11) **EP 2 519 087 B1**
(45) Date de publication et mention de la délivrance du brevet: **26.12.2018**
(21) Numéro de dépôt: 12165906.4
(22) Date de dépôt: 27.04.2012
(51) Int. Cl.: H05K 1/11, H05K 3/42, H05K 1/14, H05K 5/02, H05K 3/46, H05K 3/00, H05K 3/26, H05K 3/40

(54) **Capot d'encapsulation d'un système à connexions électriques, procédé de fabrication d'un tel capot, système encapsulé comprenant un tel capot et empilement de tels systèmes**
Einkapselungshülle für ein System mit elektrischen Verbindungen, Herstellungsverfahren dergleichen, mit einer solchen Hülle versehenes eingekapseltes System und Stapeln solcher Systeme
Cover for encapsulating a system with electrical connections, manufacturing process therefore, encapsulated system comprising such a cover and piling of such systems

(30) Priorité: 29.04.2011 CH 7382011
(43) Date de publication de la demande: 31.10.2012
(73) Titulaire: CSEM Centre Suisse d'Electronique et de Microtechnique SA - Recherche et Développement, 2002 Neuchâtel (CH)
(72) Inventeur: Cardot, Francis, 2000 Neuchâtel (CH); Solignac, Dominique, 1304 Penthalaz (CH); Jeanneret, Sylvain, 2013 Colombier (CH)
(74) Mandataire: P&TS SA (AG, Ltd.)

(56) Documents cités:
- WO-A1-2007/003228
- GB-A- 2 401 485
- US-A- 5 610 431
- US-A1- 2001 027 842
- US-A1- 2002 180 015
- US-A1- 2006 021 794
- US-A1- 2008 289 178
- US-A1- 2010 243 305
- US-A1- 2010 307 807
- US-A1- 2010 307 809
- US-B1- 6 331 678

## Description

### Domaine technique

La présente invention concerne un capot comportant des contacts électriques entre ses deux faces et qui est destiné à l'encapsulation hermétique de systèmes ou microsystèmes nécessitant des connexions électriques.

Plus particulièrement, laa présente invention concerne un capot comprenant une face avant et une face arrière et au moins un trou traversant reliant ladite face avant à ladite face arrière et destiné à recevoir un contact électrique. L'invention concerne également un capot pourvu d'au moins un contact électrique, un système ou microsystème encapsulé au moyen d'un tel capot ainsi qu'un procédé de fabrication d'un tel capot.

### Etat de la technique

Certains microsystèmes, capteurs ou actionneurs, dans le domaine des systèmes résonnants, des capteurs de pression, des sytèmes médicaux implantables par exemple, nécessitent d'avoir à la fois une encapsulation hermétique et de pouvoir être interfacés électriquement au travers d'un capot de ce type.

Afin de répondre à l'augmentation de la densité d'intégration notamment pour la microélectronique avancée et les microsystèmes, une voie consiste à superposer les différents éléments, tels que les puces électroniques, au lieu de les juxtaposer, pour réaliser des structures en trois dimensions. Cette stratégie requiert l'utilisation d'interconnexions conductrices verticales entre les éléments. De ce fait, des capots comprenant des contacts électriques traversant sont de plus en plus utilisés pour le packaging de microsystèmes.

Cette technologie repose en partie sur la possibilité de réaliser des vias traversant le capot, appelés TSV pour Through-Silicon Vias lorsque le capot est du silicium ou Through-Glass Vias TGV lorsque le capot est du verre.

Ce capot sera alors assemblé sur le substrat comportant le microsystème, faisant apparaitre à la fois deux zones d'assemblage ou de collage différentes : une zone périphérique destinée à assurer l'étanchéité et une zone destiné au contactage électrique. L'assemblage peut être réalisé par différentes techniques, telles que la soudure, la thermocompression, l'anodic bonding ou le collage.

Grâce à ces contacts, des connexions électriques sont possibles sur les deux faces du capot. Ainsi, dans le domaine de la microélectronique et des MEMS (Micro Electro Mechanical Systems), ces contacts permettent la formation de systèmes complexes d'empilage et l'interconnexion des différentes puces. Ces contacts sont aussi très utiles pour l'encapsulation sous atmosphère contrôlée de MEMS.

La plupart du temps, ces contacts sont réalisés par perçage d'un trou au travers du capot. Lorsque le capot est du silicium par exemple, les parois du trou traversant sont alors recouvertes d'une couche isolante. Le trou traversant est ensuite rempli de métal, soit sous forme de pâte métallique, soit par un procédé galvanique faisant intervenir un dépôt à partir d'une base métallique assemblée sur le capot ou via une première couche métallique déposée par évaporation.

Généralement, ces trous traversant ont un profil droit, tel que décrit dans la demande de brevet US 2004/264152, ou légèrement conique, tel que décrit dans les demandes WO 2004/095573 ou US 2010/096712. Il est nécessaire de prévoir une surcroissance ou une protubérance de métal afin d'assurer la stabilité mécanique du contact ainsi réalisé, à la manière d'un rivet, tel que cela est décrit dans la publication IMEC, Scientific Report 2008, 3D wafer level packaging (3D-WLP) ou dans la demande US 2011/012248. De telles protubérances peuvent être prévues sur l'une ou l'autre des faces du capot, voire sur les deux faces.

Un des problèmes rencontrés avec ce type de contact est que la forme de rivet induit des surépaisseurs à la surface du capot, ce qui peut être pénalisant pour les étapes d'assemblage, notamment pour la thermocompression qui nécessite une topologie plane et une très faible rugosité, ainsi que pour des étapes ultérieures de fabrication d'un système en surface du capot, ou alors de réalisation de micro-éléments flexibles de contact par une fabrication basée sur la microphotolithographie, pour lesquels un ressort par exemple est ajouté à la surface du contact électrique.

Un autre problème rencontré par ce type de contact est la résistance mécanique verticale. En effet, lors d'un assemblage par thermocompression une force mécanique est appliquée sur le contact, pouvant le fragiliser ou le déplacer, ce qui induira un contact défaillant mais surtout une perte d'étanchéité. Ce contact doit donc avoir une excellente stabilité mécanique quel que soit le sens de la force appliquée. En effet, un assemblage ultérieur peut être réalisé pour la fabrication d'un assemblage ou empilement de capteurs ou pour le montage sur un substrat d'interface, de type PCB par exemple. D'autre part, lors de son utilisation, ce système peut présenter de grandes différences de pression (gaz ou liquide) entre l'extérieur et l'intérieur de la cavité hermétique formée entre le substrat et le capot.

Un autre problème rencontré avec ce type de contact est la tenue en température. En effet, le matériau constituant le via a généralement un coefficient de dilatation plus élevé que celui du capot. De ce fait, le chauffage du capot provoque une concentration de contrainte sous les deux têtes du rivet, conduisant à des fissures dans le capot, tel que cela est décrit dans la publication Failure Mechanisms and Optimum Design for Electroplated Copper Through-Silicon Vias, Xi Liu and col., 2009 Electronic Components and Technology Conférence.

La matière définie au préambule des revendications 1,12,21 et 22 est connu des documents US-A-5610431 et US-A1-2008289178.

Un objet de la présente invention est de proposer un capot d'encapsulation d'un système MEMS à connexions électriques, ledit capot comprenant des contacts électriques traversants qui sont peu sensibles aux effets thermiques et stables mécaniquement afin de permettre un assemblage par thermocompression.

Un autre objet de la présente invention est de proposer un capot d'un système MEMS comprenant des contacts électriques traversant présentant une forme permettant un assemblage par empilement optimum de différents systèmes.

### Divulgation de l'invention

A cet effet, et conformément à la présente invention, il est proposé un capot d'encapsulation hermétique d'un système ou microsystème à connexions électriques, ledit capot comprenant une face avant et une face arrière et au moins un trou traversant reliant ladite face avant à ladite face arrière et destiné à recevoir un contact électrique. Selon l'invention, ledit trou traversant présente au moins une partie convergente et au moins une partie divergente reliées par un col de jonction.

Le contact électrique créé par remplissage d'un tel trou traversant est stable mécaniquement sans qu'il soit nécessaire de prévoir des protubérances à la surface du capot. Le contact électrique ne présente ainsi pas de partie hors du plan des deux faces du capot, permettant un empilage optimum de plusieurs systèmes.

La présente invention concerne également un procédé de fabrication d'un capot tel que défini ci-dessus, ledit procédé comprenant une étape de formation dans le capot d'un trou traversant reliant la face avant à la face arrière et destiné à recevoir un contact électrique, ledit trou traversant présentant au moins une partie convergente et au moins une partie divergente reliées par un col de jonction.

La présente invention concerne également un procédé de fabrication d'un capot tel que défini ci-dessus et comprenant, disposé dans son trou traversant, un contact électrique réalisé dans au moins une matière conductrice, ledit procédé comprenant une étape de formation dans le capot d'un trou traversant reliant la face avant à la face arrière et destiné à recevoir un contact électrique, ledit trou traversant présentant au moins une partie convergente et au moins une partie divergente reliées par un col de jonction, et une étape de dépôt de ladite matière conductrice dans le trou traversant.

La présente invention concerne également un système ou microsystème encapsulé nécessitant des connexions électriques, comprenant au moins un substrat assemblé de manière hermétique à au moins un capot tel que défini ci-dessus et comprenant, disposé dans au moins un trou traversant, au moins un contact électrique, et des moyens de connexion électrique entre ledit système et le contact électrique.

La présente invention concerne également un empilement de systèmes ou microsystèmes encapsulés nécessitant des connexions électriques, comprenant au moins deux substrats assemblés respectivement, de manière hermétique, à au moins un capot tel que défini ci-dessus et comprenant, disposé dans au moins un trou traversant, au moins un contact électrique, et des moyens de connexion électrique entre chacun desdits systèmes et le contact électrique.

### Brève description des dessins

D'autres détails de l'invention apparaîtront plus clairement à la lecture de la description qui suit, faite en référence aux dessins annexés dans lesquels :
- la figure 1 est une vue en coupe d'un capot présentant un trou traversant selon l'invention,
- la figure 2 est une vue en coupe d'un capot comprenant un contact électrique traversant selon l'invention,
- la figure 3 représente les différentes étapes d'un procédé de fabrication d'un capot comprenant un contact électrique traversant selon l'invention,
- la figure 4 représente un capot selon l'invention comprenant un élément flexible,
- la figure 5 représente un système encapsulé au moyen d'un capot selon l'invention, et
- la figure 6 représente un empilement de systèmes encapsulés au moyen d'un capot selon l'invention.

### Modes de réalisation de l'invention

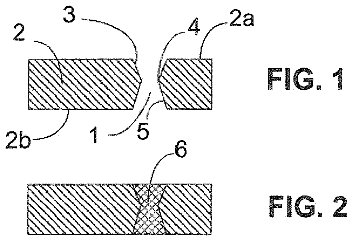

En référence aux figures 1 et 2, il est représenté un exemple de capot comprenant respectivement un trou traversant et un contact électrique traversant selon l'invention.

Le capot 2 comprend une face avant 2a et une face arrière 2b et au moins un trou traversant 1 reliant ladite face avant 2a à ladite face arrière 2b et destiné à recevoir un contact électrique 6.

La face intérieure du capot peut être plane ou présenter une forme intérieure adaptée pour recevoir un microsystème.

Conformément à l'invention, ledit trou traversant 1 présente une partie convergente 3 et une partie divergente 5 reliées par un col de jonction 4.

D'une manière préférée, la partie convergente 3 converge depuis la face avant 2a du capot 2 jusqu'audit col de jonction 4 et la partie divergente 5 diverge depuis le col de jonction 4 jusqu'à la face arrière 2b du capot 2.

Selon la variante de réalisation représentée ici, ledit trou traversant 1 comprend des parois convergentes ou divergentes qui, en section axiale, présentent une forme droite. Ainsi, le trou traversant 1 présente la forme de deux troncs de cône opposés par le sommet et reliés par le col de jonction 4.

Dans une autre variante de réalisation non représentée, le trou traversant peut comprendre des parois convergentes ou divergentes qui, en section axiale, présentent une forme courbe, de sorte que le trou traversant présente une forme de diabolo.

La section transversale du trou traversant peut être de toute forme, telle que ronde, carrée, ou rectangulaire.

De préférence, le col de jonction 4 se situe, par rapport à chacune des faces avant 2a et arrière 2b du capot 2, à une distance correspondant à au moins 10%, de préférence au moins 15%, de l'épaisseur du capot 2.

Par ailleurs, la partie convergente 3, respectivement la partie divergente 5, est avantageusement réalisée de sorte que son angle d'ouverture α par rapport au plan de la face avant 2a, respectivement arrière 2b, du capot 2 est compris entre 60° et 85°, et de préférence compris entre 68° et 78°.

Le capot 2 peut être une plaque en verre, en céramique, en polymère (pur ou composite) ou en matériau semi-conducteur, tel que du silicium.

Le capot 2 peut présenter une épaisseur comprise entre 50 µm et 2 mm, et de préférence comprise entre 150 µm et 1 mm.

De plus, les dimensions des parties convergente 3 et divergente 5 sont de préférence telles que les dimensions de l'ouverture du trou traversant pris à la surface du capot 2 sont comprises entre 10 µm et 500 µm, et de préférence compris entre 100 µm et 300 µm.

De préférence, le col de jonction 4 présente une ouverture dont la dimension est inférieure à 80% de la dimension de la plus petite ouverture du trou traversant, prise à la surface de la face avant 2a ou de la face arrière 2b du capot 2. La dimension de l'ouverture du col de jonction est toutefois suffisante pour permettre le remplissage du trou traversant par la matière conductrice pour former le contact électrique.

D'une manière avantageuse, le trou traversant 1 ne présente qu'un seul col de jonction 4 de sorte que tous les capots présentant des trous traversant formés par recuit et présentant des rugosités ne font pas partie de l'invention.

Le contact électrique 6 disposé dans le trou traversant 1 formé selon l'invention dans le capot 2, est réalisé dans au moins une matière conductrice qui peut comprendre au moins un métal ou au moins un alliage métallique, tel que le cuivre, l'or ou tout autre métal ou alliage métallique approprié.

D'une manière avantageuse, la matière conductrice comprend un premier matériau conducteur constituant au moins partiellement ledit contact électrique 6.

D'une manière préférée, ledit premier matériau conducteur a un coefficient d'expansion thermique présentant une différence d'au plus 3 ppm par rapport à celui du capot 2.

D'une manière avantageuse, ledit premier matériau conducteur est un alliage de fer et de nickel, dans lequel la teneur massique en nickel est comprise entre 20% et 80%, de préférence entre 25% et 50%, et plus préférentiellement entre 32% et 40% de l'alliage.

En outre, dans le cas où le premier matériau conducteur ne constitue qu'une partie du contact électrique, la matière conductrice dudit contact électrique peut comprendre au moins un deuxième matériau conducteur. Ledit au moins deuxième matériau conducteur peut être présent sous la forme de couches, par exemple alternées avec des couches du premier matériau conducteur, ou peut former avec ledit premier matériau conducteur un ensemble hétérogène. Le deuxième matériau peut par exemple être prévu sous la forme d'une couche à la surface du contact électrique. Le deuxième matériau conducteur peut être de l'or ou tout autre métal ou alliage métallique approprié.

Grâce à la forme spécifique du trou traversant réalisé dans le capot, le contact électrique 6, créé par remplissage dudit trou traversant 1, est stable mécaniquement. Il est de ce fait insensible aux poussées verticales que l'on pourrait lui appliquer. En conséquence, le contact électrique 6 ne nécessite pas de parties débordant sur les faces du capot 2. Ainsi, le contact électrique 6 présente des surfaces libres planes qui arrivent à fleur respectivement de la face avant 2a et de la face arrière 2b du capot 2.

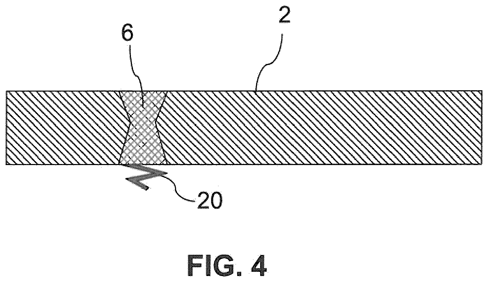

Un des avantages de cette invention est la réalisation de micro-éléments flexibles de contact par une fabrication basée sur la microphotolithographie, tel que représenté sur la figure 4 : le capot 2 selon l'invention comprend un élément flexible 20 prévu à la surface plane du contact électrique 6.

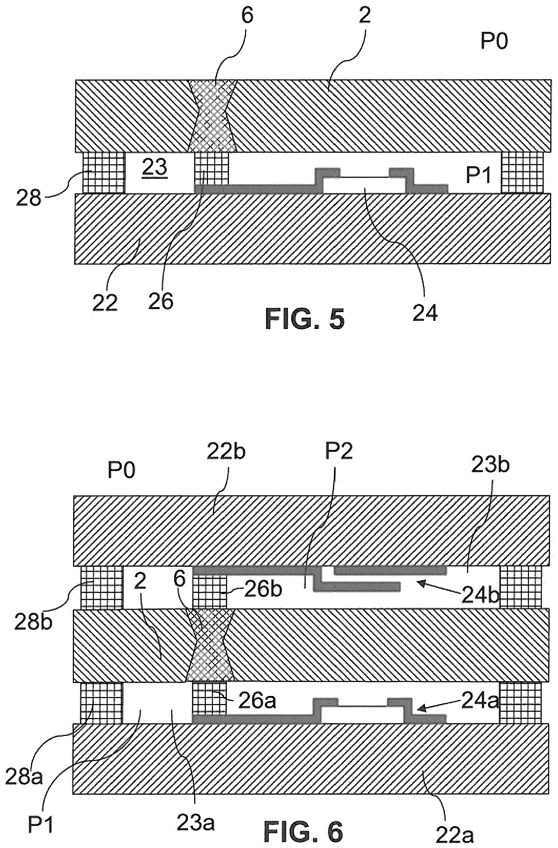

La figure 5 représente un système encapsulé comprenant un substrat 22 assemblé de manière étanche à un capot 2 selon l'invention. Dans la cavité 23 formée entre le substrat 22 et le capot 2 est prévu un système ou microsystème 24, tel qu'un MEMS. La connexion électrique entre le contact 6 du capot 2 et le microsystème 24 est réalisée au moyen d'une soudure d'interfaçage 26. L'étanchéité de l'assemblage est réalisée au moyen d'un cordon de soudure 28. Un tel système peut consister par exemple en des composants électroniques ou des microcapteurs qui doivent être encapsulés afin de placer l'élément sensible en atmosphère contrôlée. Ainsi il peut régner une pression P1 à l'intérieur de la cavité, différente de la pression extérieure P0. La forme spécifique du contact traversant 6 selon l'invention permet à ce dernier de rester en place et de préserver l'étanchéité du système, même en cas de très grande différence de pression entre l'intérieur de la cavité 23 et l'extérieur du système. Un autre avantage de la forme du contact traversant est que lors de l'assemblage du capot 2 et du substrat 22, la surface intérieure du contact 6 est à la même hauteur que le cordon de soudure 28, ce qui facilite l'assemblage par thermocompression.

Un autre avantage de l'invention est que l'empilement de systèmes encapsulés utilisant un tel capot est optimum et n'est pas gêné par d'éventuelles surépaisseurs à la surface du capot. La figure 6 montre un exemple de réalisation d'un tel empilement, comprenant deux microsystèmes 24a, 24b, par exemple de type MEMS, prévus chacun sur un substrat 22a, 22b respectivement, et reliés par un capot 2 selon l'invention. Ledit capot 2 permet, avec les cordons de soudure 28a, 28b d'encapsuler les systèmes 24a, 24b. Les connexions électriques entre les microsystèmes 24a, 24b sont réalisées au moyen des soudures d'interfaçage 26a, 26b reliant le contact électrique 6 au microsystème 24a, 24b, respectivement. Comme pour l'exemple de la figure 5, il peut régner une pression P1 à l'intérieur de la première cavité 23a, une pression P2 à l'intérieur de la deuxième cavité 23b, différentes l'une de l'autre, et différentes également de la pression extérieure P0.

D'autre part la tenue en température du contact électrique 6 selon l'invention est bien meilleure que les contacts à parois droite et en forme de rivet. En effet, lors d'une dilation plus importante du métal constituant le contact électrique que du matériau du capot, les forces exercées latéralement sont beaucoup plus faibles car l'inclinaison des parois du trou décompose cette force d'appui en une composante latérale et une composante verticale.

La présente invention concerne également un procédé de fabrication d'un capot tel que décrit ci-dessus, comprenant une étape de formation dans le capot 2 d'un trou traversant 1 reliant la face avant 2a à la face arrière 2b du capot 2, ledit trou traversant 1 présentant au moins une partie convergente 3 et au moins une partie divergente 5 reliées par un col de jonction 4.

D'une manière avantageuse, le trou traversant est formé par un procédé de gravure au travers d'un masque. Plus particulièrement, la forme du trou traversant selon l'invention peut être obtenue en utilisant depuis chaque face du capot un procédé de gravure, par exemple anisotrope, au travers d'un masque, tel qu'une attaque humide, une gravure par plasma ou une gravure par sablage.

En outre, le procédé selon l'invention comprend une étape de dépôt, dans le trou traversant, de la matière conductrice dans laquelle est réalisé le contact électrique. De préférence, la matière conductrice remplit entièrement le trou traversant de sorte que les surfaces libres du contact électrique arrivent à fleur respectivement de la face avant 2a et de la face arrière 2b du capot 2.

Selon les modes de réalisation, la matière conductrice peut être déposée par voie galvanique ou sous la forme d'une pâte stabilisée par chauffage après sa mise en place dans le trou traversant.

Dans le cas où le capot est réalisé dans un matériau conducteur, les parois du trou doivent être recouvertes d'un isolant électrique, par exemple par formation d'un oxyde thermique dans le cas du silicium.

Le procédé selon l'invention peut comprendre, entre l'étape de formation du trou traversant et l'étape de dépôt de la matière conductrice, une étape de positionnement d'une feuille conductrice sur l'une des faces avant et arrière du capot. Le procédé selon l'invention peut comprendre, préalablement à l'étape de positionnement de ladite feuille conductrice, une étape de dépôt, sur l'une des faces avant et arrière du capot, d'un matériau adhésif présentant une viscosité contrôlée de manière à ne pas pénétrer dans le trou traversant. Selon une autre variante, le procédé selon l'invention peut comprendre, préalablement à l'étape de positionnement de ladite feuille conductrice, une étape de dépôt, sur l'une des faces avant et arrière du capot, d'un matériau adhésif présentant une ouverture au niveau du trou traversant. Plus particulièrement, ledit matériau adhésif peut être déposé sélectivement sur une des faces de manière à ne pas boucher les trous de contact, par une méthode d'impression de type jet d'encre par exemple, ou alors il peut être déposé sur toute la face, sous la forme d'un film de colle, et ensuite être ouvert sélectivement pour dégager les trous.

Le procédé selon l'invention comprend en outre une étape de finition comprenant un traitement mécanique de la surface du capot, permettant d'obtenir un capot comprenant des contacts électriques traversants plan et poli.

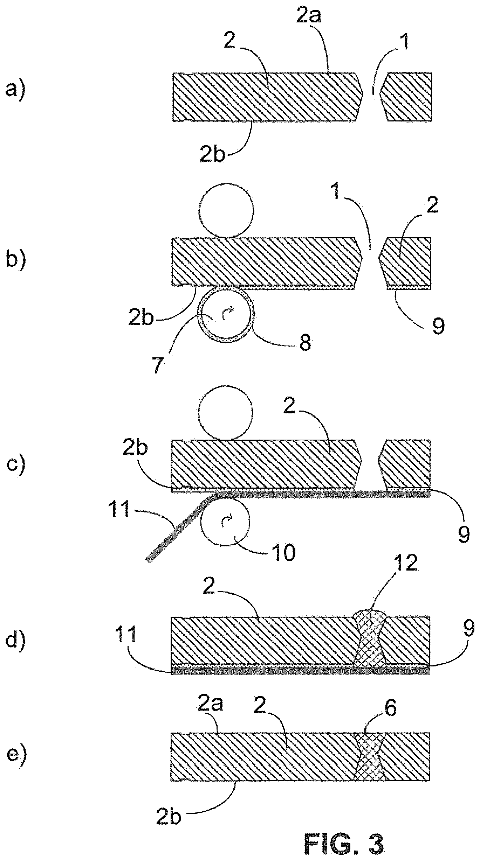

En référence à la figure 3, il est décrit un mode de réalisation préféré du procédé selon l'invention.

A l'étape a), le capot 2, ici choisi isolant au départ, est percé d'un trou traversant 1 présentant le profil selon l'invention, au moyen d'une attaque sur chaque face du capot 2 par sablage au travers de masques de résine.

A l'étape b), après retrait des masques, une couche de matériau adhésif 8, par exemple une colle, est appliquée au moyen d'un système de dispense identique à ceux des systèmes d'encrage utilisés en imprimerie. De cette manière, une couche de colle d'épaisseur contrôlée 9 est déposée uniquement sur la face arrière 2b du capot 2 qui a été en contact avec le rouleau applicateur 7. La viscosité de la colle est choisie de façon à ce qu'elle ne coule pas dans le trou traversant 1.

A l'étape c), une feuille de métal 11, par exemple en laiton, est alors appliquée sur la face arrière 2b du capot 2 par pression sur la couche de colle 9 au moyen de rouleaux de laminage 10. La face non collée de la feuille de métal 11 peut être recouverte d'un isolant électrique (non représenté).

A l'étape d), le fond du trou traversant 1 est alors constitué de la surface conductrice de la feuille métallique 11 à partir de laquelle une déposition galvanique d'un métal ou d'un alliage métallique permet de réaliser un contact électrique 12 au travers du capot 2.

A l'étape e), un rodage et un polissage sur les deux faces avant 2a et arrière 2b du capot 2 permettent alors d'obtenir un capot plan et poli, avec un contact électrique 6 traversant et étanche. La feuille métallique 11 peut toutefois être conservée au moins partiellement pour permettre de graver des pistes pour réaliser des interconnections.

La présente invention concerne également un capot comprenant une face avant et une face arrière, au moins un trou traversant reliant ladite face avant à ladite face arrière, et un contact électrique disposé dans ledit trou traversant et réalisé dans une matière conductrice constituée au moins partiellement d'un matériau conducteur. Ledit matériau conducteur est un alliage de fer et de nickel, dans lequel la teneur massique en nickel est comprise entre 20% et 80%, de préférence entre 25% et 50%, et plus préférentiellement entre 32% et 40% de l'alliage. Un tel alliage permet de régler le coefficient d'expansion thermique du matériau constituant le contact pour qu'il présente une différence d'au plus 3 ppm par rapport à celui du capot. L'alliage fer/nickel pour remplir tout ou partie du trou traversant pour former tout ou partie du contact électrique. Le trou traversant peut être de toute forme.

## Revendications

1. Capot (2) d'encapsulation d'un système MEMS nécessitant des connexions électriques, ledit capot (2) comprenant une face avant (2a) et une face arrière (2b) et au moins un trou traversant (1) reliant ladite face avant (2a) à ladite face arrière (2b) et destiné à recevoir un contact électrique (6), **caractérisé en ce que** ledit trou traversant (1) présente au moins une partie convergente (3) et au moins une partie divergente (5) reliées par un col de jonction (4) et **en ce que** le contact électrique (6) ne présente pas de partie hors du plan des dites deux faces (2a,2b).

2. Capot selon la revendication 1, **caractérisé en ce que** la partie convergente (3) converge depuis la face avant (2a) du capot (2) jusqu'audit col de jonction (4).

3. Capot selon l'une des revendications 1 et 2, **caractérisé en ce que** la partie divergente (5) diverge depuis le col de jonction (4) jusqu'à la face arrière (2b) du capot (2).

4. Capot selon l'une des revendications précédentes, **caractérisé en ce que** ledit trou traversant (1) comprend des parois qui, en section axiale, présentent une forme droite de sorte que le trou traversant (1) présente la forme de deux troncs de cône opposés par le sommet et reliés par le col de jonction (4).

5. Capot selon l'une des revendications 1 à 3, **caractérisé en ce que** ledit trou traversant (1) comprend des parois qui, en section axiale, présentent une forme courbe.

6. Capot selon l'une quelconque des revendications précédentes, **caractérisé en ce que** le col de jonction (4) se situe, par rapport à chacune des faces avant (2a) et arrière (2b) du capot (2), à une distance correspondant à au moins 10% de l'épaisseur du capot (2).

7. Capot selon l'une quelconque des revendications précédentes, **caractérisé en ce que** l'angle d'ouverture (a) de la partie convergente (3), respectivement divergente (5), par rapport au plan de la face avant (2a), respectivement arrière (2b), du capot (2) est compris entre 60° et 85°.

8. Capot selon l'une quelconque des revendications précédentes, comprenant, disposé dans ledit trou traversant (1), un contact électrique (6) réalisé dans au moins une matière conductrice comprenant au moins un métal ou au moins un alliage métallique.

9. Capot selon la revendication 8, **caractérisé en ce que** la matière conductrice comprend un premier matériau conducteur constituant au moins partiellement ledit contact électrique.

10. Capot selon la revendication 9, **caractérisé en ce que** ledit premier matériau conducteur a un coefficient d'expansion thermique présentant une différence d'au plus 3 ppm par rapport à celui du capot (2).

11. Capot selon la revendication 9 ou 10, **caractérisé en ce que** ledit premier matériau conducteur est un alliage de fer et de nickel, dans lequel la teneur massique en nickel est comprise entre 20% et 80%, de préférence entre 25% et 50%, et plus préférentiellement entre 32% et 40% de l'alliage.

12. Procédé de fabrication d'un capot d'un système MEMS selon l'une quelconque des revendications 1 à 11, **caractérisé en ce qu'**il comprend une étape de formation dans le capot (2) d'un trou traversant (1) reliant la face avant (2a) à la face arrière (2b) et destiné à recevoir un contact électrique (6), ledit trou traversant (1) présentant au moins une partie convergente (3) et au moins une partie divergente (5) reliées par un col de jonction (4), et **en ce que** le procédé fournit une surface plane du capot (2).

13. Procédé selon la revendication 12, **caractérisé en ce que** le trou traversant (1) est formé par un procédé de gravure au travers d'un masque.

14. Procédé de fabrication d'un capot selon l'une quelconque des revendications 8 à 11, ledit capot (2) comprenant, disposé dans ledit trou traversant (1), un contact électrique (6) réalisé dans au moins une matière conductrice, **caractérisé en ce qu'**il comprend une étape de formation dans le capot (2) d'un trou traversant (1) reliant la face avant (2a) à la face arrière (2b) et destiné à recevoir un contact électrique (6), ledit trou traversant (1) présentant au moins une partie convergente (3) et au moins une partie divergente (5) reliées par un col de jonction (4), et une étape de dépôt de ladite matière conductrice dans le trou traversant (1).

15. Procédé selon la revendication 14, **caractérisé en ce que** la matière conductrice est déposée par voie galvanique.

16. Procédé selon la revendication 14, **caractérisé en ce que** la matière conductrice est déposée sous la forme d'une pâte stabilisée par chauffage après sa mise en place dans le trou traversant (1).

17. Procédé selon la revendication 15, **caractérisé en ce qu'**il comprend, entre l'étape de formation du trou traversant (1) et l'étape de dépôt de la matière conductrice, une étape de positionnement d'une feuille conductrice (11) sur l'une des faces avant (2a) et arrière (2b) du capot (2).

18. Procédé selon la revendication 17, **caractérisé en ce qu'**il comprend, préalablement à l'étape de positionnement de ladite feuille conductrice (11), une étape de dépôt, sur l'une des faces avant (2a) et arrière (2b) du capot (2), d'un matériau adhésif (8) présentant une viscosité contrôlée de manière à ne pas pénétrer dans le trou traversant (1).

19. Procédé selon la revendication 17, **caractérisé en ce qu'**il comprend, préalablement à l'étape de positionnement de ladite feuille conductrice (11), une étape de dépôt, sur l'une des faces avant (2a) et arrière (2b) du capot (2), d'un matériau adhésif (8) présentant une ouverture au niveau du trou traversant (1).

20. Procédé selon l'une des revendications 14 à 19, **caractérisé en ce qu'**il comprend une étape de finition comprenant un traitement mécanique de la surface du capot (2).

21. Système (24) encapsulé nécessitant des connexions électriques, comprenant au moins un substrat (22) assemblé de manière hermétique à au moins un capot (2) selon l'une quelconque des revendications 1 à 11 et comprenant, disposé dans au moins un trou traversant (1), au moins un contact électrique (6), et des moyens de connexion électrique (26) entre ledit système (24) et le contact électrique (6).

22. Empilement de systèmes (24a, 24b) encapsulés nécessitant des connexions électriques, comprenant au moins deux substrats (22a, 22b) assemblés respectivement, de manière hermétique, à au moins un capot (2) selon l'une quelconque des revendications 1 à 11 et comprenant, disposé dans au moins un trou traversant (1), au moins un contact électrique (6), et des moyens de connexion électrique (26a, 26b) entre chacun desdits systèmes (24a, 24b) et le contact électrique (6).

## Patentansprüche

1. Hülle (2) zum Einkapseln eines MEMS-Systems, welches elektrische Verbindungen erfordert, wobei die besagte Hülle (2) eine Vorderseite (2a) und eine Rückseite (2b) und mindestens ein Durchgangsloch (1) aufweist, welches die besagte Vorderseite (2a) mit der besagten Rückseite (2b) verbindet und zur Aufnahme eines elektrischen Kontakts (6) vorgesehen ist, **dadurch gekennzeichnet, dass** das besagte Durchgangsloch (1) mindestens einen konvergenten Abschnitt (3) und mindestens einen divergierenden Abschnitt (5) aufweist, welche durch einen Verbindungshals (4) verbunden sind, und dass der elektrische Kontakt (6) keinen Teil ausserhalb der Ebene der besagten beiden Seiten (2a, 2b) aufweist.

2. Hülle gemäss Anspruch 1, **dadurch gekennzeichnet, dass** der konvergierende Abschnitt (3) von der Vorderseite (2a) der Hülle (2) zum besagten Verbindungshals (4) konvergiert.

3. Hülle gemäss einem der Ansprüche 1 und 2, **dadurch gekennzeichnet, dass** der divergierende Abschnitt (5) vom Verbindungshals (4) zur Rückseite (2b) der Hülle (2) divergiert.

4. Hülle gemäss einem der vorhergehenden Ansprüche, **dadurch gekennzeichnet, dass** das besagte Durchgangsloch (1) Wände aufweist, welche im Axialschnitt eine gerade Form aufweisen, so dass das Durchgangsloch (1) die Form von zwei sich an der Spitze gegenüberliegenden Kegelstümpfen hat, welche durch den Verbindungshals (4) verbunden sind.

5. Hülle gemäss einem der Ansprüche 1 bis 3, **dadurch gekennzeichnet, dass** das besagte Durchgangsloch (1) Wände aufweist, die im Axialschnitt eine gekrümmte Form aufweisen.

6. Hülle gemäss irgendeinem der vorhergehenden Ansprüche, **dadurch gekennzeichnet, dass** der Verbindungshals (4) in Bezug auf die Vorderseite (2a) und Rückseite (2b) der Hülle (2) jeweils einen Abstand aufweist, der mindestens 10% der Dicke der Hülle (2) entspricht.

7. Hülle gemäss irgendeinem der vorhergehenden Ansprüche, **dadurch gekennzeichnet, dass** der Öffnungswinkel (a) des konvergenten Abschnitts (3) bzw. des divergierenden Abschnitts (5) in Bezug auf die Ebene der Vorderseite (2a) bzw. Rückseite (2b) der Hülle (2) zwischen 60° und 85° liegt.

8. Hülle gemäss irgendeinem der vorhergehenden Ansprüche, mit einem im besagten Durchgangsloch (1) angeordneten elektrischen Kontakt (6), welcher aus mindestens einem leitenden Material ausgeführt ist, welches mindestens ein Metall oder mindestens eine Metalllegierung umfasst.

9. Hülle gemäss Anspruch 8, **dadurch gekennzeichnet, dass** das leitfähige Material ein erstes leitfähiges Material umfasst, welches zumindest teilweise den besagten elektrischen Kontakt bildet.

10. Hülle gemäss Anspruch 9, **dadurch gekennzeichnet, dass** das besagte erste leitende Material einen Wärmeausdehnungskoeffizienten aufweist, der eine Differenz von höchstens 3 ppm im Vergleich zu demjenigen der Hülle (2) aufweist.

11. Hülle gemäss Anspruch 9 oder 10, **dadurch gekennzeichnet, dass** das besagte erste leitfähige Material eine Legierung aus Eisen und Nickel ist, worin der Massengehalt von Nickel zwischen 20% und 80%, vorzugsweise zwischen 25% und 50% und noch stärker bevorzugt zwischen 32% und 40% der Legierung liegt.

12. Verfahren zur Herstellung einer Hülle eines MEMS-Systems gemäss irgendeinem der Ansprüche 1 bis 11, **dadurch gekennzeichnet, dass** es einen Schritt des Ausbildens, in der Hülle (2), von einem die Vorderseite (2a) mit der Rückseite (2b) verbindenden Durchgangslochs (1) umfasst, und welches zur Aufnahme eines elektrischen Kontakts (6) bestimmt ist, wobei das besagte Durchgangsloch (1) mindestens einen konvergierenden Abschnitt (3) und mindestens einen divergierenden Abschnitt (5) aufweist, welche durch einen Verbindungshals (4) verbunden sind, und dass das Verfahren eine ebene Fläche der Hülle (2) bietet.

13. Verfahren gemäss Anspruch 12, **dadurch gekennzeichnet, dass** das Durchgangsloch (1) durch einen Ätzprozess durch eine Maske gebildet wird.

14. Verfahren zur Herstellung einer Hülle gemäss irgendeinem der Ansprüche 8 bis 11, wobei die besagte Hülle (2) einen im Durchgangsloch (1) angeordneten elektrischen Kontakt (6) aufweist, welcher aus mindestens einem leitenden Material ausgeführt ist, **dadurch gekennzeichnet, dass** sie umfasst: einen Schritt des Ausbildens, in der Hülle, von einem die Vorderseite (2a) mit der Rückseite (2b) verbindenden Durchgangslochs (1), welches zur Aufnahme eines elektrischen Kontakts (6) bestimmt ist, wobei das besagte Durchgangsloch (1) mindestens einen konvergierenden Abschnitt (3) und mindestens einen divergierenden Abschnitt (5) aufweist, welche durch einen Verbindungshals (4) verbunden sind, und einen Schritt des Abscheidens des besagten leitenden Materials im Durchgangsloch (1).

15. Verfahren gemäss Anspruch 14, **dadurch gekennzeichnet, dass** das leitfähige Material elektroplattiert ist.

16. Verfahren gemäss Anspruch 14, **dadurch gekennzeichnet, dass** das leitfähige Material in Form einer wärmestabilisierten Paste nach dem Einbringen in das Durchgangsloch (1) abgeschieden wird.

17. Verfahren gemäss Anspruch 15, **dadurch gekennzeichnet, dass** es aufweist, zwischen dem Schritt des Ausbildens des Durchgangslochs (1) und dem Schritt des Abscheidens des leitfähigen Materials, einen Schritt des Positionierens einer leitfähigen Folie (11) auf einer der Vorderseite (2a) und Rückseite (2b) der Hülle (2).

18. Verfahren gemäss Anspruch 17, **dadurch gekennzeichnet, dass** es umfasst, vor dem Schritt des Positionierens der besagten leitfähigen Folie (11), einen Schritt der Abscheidung, auf einer der Vorderseite (2a) und Rückseite (2b) der Hülle (2), von einem Klebematerial (8) mit einer derart kontrollierten Viskosität, dass sie nicht durch das Durchgangsloch (1) dringt.

19. Verfahren gemäss Anspruch 17, **dadurch gekennzeichnet, dass** es umfasst, vor dem Schritt des Positionierens der besagten leitfähigen Folie (11), einen Schritt der Abscheidung, auf einer der Vorderseite (2a) und Rückseite (2b) der Hülle (2), von einem Klebematerial (8) mit einer Öffnung an der Durchgangsöffnung (1).

20. Verfahren gemäss einem der Ansprüche 14 bis 19, **dadurch gekennzeichnet, dass** es einen Endbearbeitungsschritt umfasst, mit einer mechanischen Behandlung der Oberfläche der Hülle (2).

21. Gekapseltes System (24), welches elektrische Verbindungen erfordert, umfassend mindestens ein Substrat (22), welches hermetisch mit mindestens einer Hülle (2) gemäss irgendeinem der Ansprüche 1 bis 11 verbunden ist, und mit
mindestens einem Durchgangsloch (1), mindestens einem elektrischen Kontakt (6) und elektrischen Verbindungsmitteln (26) zwischen dem besagten System (24) und dem elektrischen Kontakt (6).

22. Stapel von gekapselten Systemen (24a, 24b), welche elektrische Verbindungen erfordern, umfassend mindestens zwei Substrate (22a, 22b), welche jeweils mit mindestens einer Hülle (2) gemäss irgendeinem der Ansprüche 1 bis 11 hermetisch verbunden sind, und mit
mindestens einem Durchgangsloch (1), mindestens einem elektrischen Kontakt (6) und elektrischen Verbindungsmitteln (26) zwischen dem System (24) und dem elektrischen Kontakt (6).

## Claims

1. Cover (2) for encapsulating a MEMS system requiring electrical connections, said cover (2) comprising a front face (2a) and a rear face (2b) and at least one through hole (1) connecting said front face (2a) to said rear face (2b) and designed to receive an electrical contact (6), **characterized in that** said through hole (1) has at least one convergent portion (3) and at least one diverging portion (5) connected by a junction neck (4) and **in that** the electrical contact (6) has no part extending out of the plane of said two faces (2a, 2b).

2. Cover according to claim 1, **characterized in that** the converging portion (3) converges from the front face (2a) of the cover (2) to said junction neck (4).

3. Cover according to one of claims 1 and 2, **characterized in that** the diverging portion (5) diverges from the junction neck (4) up to the rear face (2b) of the cover (2).

4. Cover according to one of the preceding claims, **characterized in that** said through hole (1) comprises walls which, in axial section, have a straight shape so that the through hole (1) has the shape of two cone frustums opposed at the top and connected by the junction neck (4).

5. Cover according to one of claims 1 to 3, **characterized in that** said through hole (1) comprises walls which, in axial section, have a curved shape.

6. Cover according to any one of the preceding claims, **characterized in that** the junction neck (4) is, with respect to each of the front (2a) and rear (2b) faces of the cover (2), at a distance corresponding to at least 10% of the thickness of the cover (2).

7. Cover according to any one of the preceding claims, **characterized in that** the opening angle (α) of the convergent portion (3), respectively divergent portion (5), relative to the plane of the front face (2a), respectively rear face (2b), of the cover (2) is comprised between 60° and 85°.

8. Cover according to any one of the preceding claims, comprising, arranged in said through hole (1), an electrical contact (6) formed in at least one conductive material comprising at least one metal or at least one metal alloy.

9. Cover according to claim 8, **characterized in that** the conductive material comprises a first conductive material constituting at least partially said electrical contact.

10. Cover according to claim 9, **characterized in that** said first conductive material has a thermal expansion coefficient having a difference of at most 3 ppm relative to that of the cover (2).

11. Cover according to claim 9 or 10, **characterized in that** said first conductive material is an alloy of iron and nickel, wherein the mass content of nickel is between 20% and 80%, preferably between 25% and 50%, and more preferably between 32% and 40% of the alloy.

12. Method of manufacturing a cover of a MEMS system according to any one of claims 1 to 11, **characterized in that** it comprises a step of forming in the cover (2) a through hole (1) connecting the front face (2a) to the rear face (2b) and designed to receive an electrical contact (6), said through hole (1) having at least one converging portion (3) and at least one diverging portion (5) connected by a junction neck (4), and **in that** the method provides a level surface of the cover (2).

13. Method according to claim 12, **characterized in that** the through hole (1) is formed by an etching process through a mask.

14. Method of manufacturing a cover according to any one of claims 8 to 11, said cover (2) comprising, arranged in said through hole (1), an electrical contact (6) formed in at least one conductive material, **characterized in that** it comprises a step of forming in the cover (2) a through hole (1) connecting the front face (2a) to the rear face (2b) and designed to receive an electrical contact (6), said hole through hole (1) having at least one converging portion (3) and at least one diverging portion (5) connected by a junction neck (4), and a step of depositing said conductive material in the through hole (1).

15. Method according to claim 14, **characterized in that** the conductive material is deposited by electroplating.

16. Method according to claim 14, **characterized in that** the conductive material is deposited in the form of a heat-stabilized paste after it has been placed in the through hole (1).

17. Method according to claim 15, **characterized in that** it comprises, between the step of forming the through hole (1) and the step of depositing the conductive material, a step of positioning a conductive sheet (11) on one of the front (2a) and rear (2b) faces of the cover (2).

18. Method according to claim 17, **characterized in that** it comprises, prior to the step of positioning said conductive sheet (11), a step of depositing on one of the front (2a) and rear (2b) faces of the cover (2), an adhesive material (8) having a controlled viscosity so as not to penetrate into the through hole (1).

19. Method according to claim 17, **characterized in that** it comprises, prior to the step of positioning said conductive sheet (11), a step of depositing on one of the front (2a) and rear (2b) faces of the cover (2), an adhesive material (8) having an opening at the level of the through hole (1).

20. Method according to one of claims 14 to 19, **characterized in that** it comprises a finishing step comprising a mechanical treatment of the surface of the cover (2).

21. Encapsulated system (24) requiring electrical connections, comprising at least one substrate (22) hermetically assembled to at least one cover (2) according to any one of claims 1 to 11 and comprising, arranged in at least one through hole (1), at least one electrical contact (6), and electrical connection means (26) between said system (24) and the electrical contact (6).

22. Stacking of encapsulated systems (24a, 24b) requiring electrical connections, comprising at least two substrates (22a, 22b) respectively assembled hermetically to at least one cover (2) according to any one of claims 1 to 11 and comprising, arranged in at least one through hole (1), at least one electrical contact (6), and electrical connection means (26a, 26b) between each of said systems (24a, 24b) and the electrical contact (6).
